# EUROPEAN PATENT APPLICATION

(11) **EP 4 632 486 A2**
(43) Date of publication of application: **15.10.2025**
(21) Application number: 25199136.0
(22) Date of filing: 29.08.2025
(51) Int. Cl.: G03F 7/00

(54) **A CONDITIONING UNIT FOR A SUBSTRATE**

(71) Applicant: ASML Netherlands B.V., 5500 AH Veldhoven (NL)
(72) Inventor: DE GROOT, Antonius Franciscus Johannes, 5500 AH Veldhoven (NL)
(74) Representative: ASML Netherlands B.V.

(57) **Abstract**

A conditioning unit for a substrate is described, the conditioning unit comprising a first body having first and second channels, each of the first and second channels in communication with one or more planar surfaces of the first body. The conditioning unit further comprises a second body having a first surface configurable to be removably secured to a planar surface of the first body. The second body further comprises a second surface configured to support the substrate. A plurality of regions in the second body are in communication with the second channels of the first body, configurable to secure the substrate.

## Description

### FIELD

The present invention relates to a conditioning unit for conditioning a substrate, a substrate handler comprising a conditioning unit for conditioning a substrate and to an exposure apparatus comprising a conditioning unit for conditioning a substrate.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask) onto a layer of radiation-sensitive material (resist) provided on a substrate (e.g., a wafer).

As semiconductor manufacturing processes continue to advance, the dimensions of circuit elements have continually been reduced while the amount of functional elements, such as transistors, per device has been steadily increasing over decades, following a trend commonly referred to as 'Moore's law'. To keep up with Moore's law the semiconductor industry is chasing technologies that enable to create increasingly smaller features. To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm. A lithographic apparatus, which uses extreme ultraviolet (EUV) radiation, having a wavelength within a range of 4 nm to 20 nm, for example 6.7 nm or 13.5 nm, may be used to form smaller features on a substrate than a lithographic apparatus which uses, for example, radiation with a wavelength of 193 nm.

A lithographic apparatus may comprise a substrate handling system for handling substrates between receipt of substrates at a substrate entry point, also referred to as a track interface, and a substrate processing area such as a substrate stage where substrates may be patterned. The substrate handling system may comprise a substrate handling module configured to receive substrates from a track, for example, via a track interface under cleanroom conditions (i.e. in ambient air having a controlled level of contaminants) and to transfer substrates to a further handling module or to a processing area. A substrate handling module may comprise a conditioning unit, to thermally condition a substrate for further processing. Substrates used during the manufacture of e.g., ICs, undergo multiple processing steps including multiple exposures. It is important that the substrate is reproducibly thermally conditioned prior to each exposure to ensure that the overlay of subsequent exposures is within required tolerances.

A known conditioning unit suffers from a low yield during manufacturing. High temperatures used during hard-soldering of parts can lead to unacceptable deformation of the conditioning unit. The surface of the conditioning unit to support a substrate to be conditioned must be flat as opposed to deformed. Another drawback of a known conditioning unit is that its support surface to support a substrate to be clamped is also hard soldered as part of the conditioning unit, and the surface to support a substrate comprises burls with a diamond-like carbon coating which can also suffer from loss of yield due to unacceptable deformation and defectivity issues on substrates.

### SUMMARY

It is an object of the invention to provide a conditioning unit that at least partially overcomes the drawbacks of a known conditioning unit outlined above.

In a first aspect of the invention there is provided a conditioning unit for a substrate, comprising: a first body comprising first and second channels, each of the first and second channels in communication with one or more planar surfaces; a second body comprising a first surface configurable to be removably secured to a planar surface of the first body, the second body further comprising a second surface configured to support the substrate, wherein the second surface comprises a plurality of regions in communication with the second channels of the first body, configurable to secure the substrate. Advantageously, in embodiments according to the invention, the second body, which is configurable to secure the substrate, is configurable to be removably secured to the first body. This allows for quick and easy exchange of parts of the conditioning unit when required due to e.g., wear, with a lower outlay in terms of both cost and downtime. The plurality of regions in communication with the second channels of the first body may be a plurality of openings.

The first surface of the second body may be in communication with the second channels of the first body.

The first and second channels may be located in one or more transverse planes of the first body.

The first body may be a monolithic body, thereby requiring fewer parts for manufacture.

The first body may alternatively comprise a first planar body and a second planar body, wherein a surface of the first planar body is in thermal communication with a surface of the second planar body. The surface of the first planar body may be sealed to the surface of the second planar body by means of an adhesive layer. Alternatively, the surface of the first planar body may be sealed to the surface of the second planar body by means of dip brazing. The seal between the first body and the second body may be water-tight. The first body and the second body may be hermetically sealed.

The conditioning unit may be arranged to receive a substrate from a track.

The first channels of the conditioning unit may be configured to convey a thermally-controlled fluid. The thermally-controlled fluid serves to thermally condition a substrate secured to the conditioning unit.

The second surface of the second body of the conditioning unit may comprise a plurality of burls. A plurality of burls results in a smaller contact surface area for a substrate, which advantageously reduces defectivity issues due to particles that may be trapped between the contact surface and the substrate.

The first body of the conditioning unit may be comprised of aluminium or steel. The second body may also be comprised of aluminium or steel, or may alternatively be comprised of silicon carbide, silicon-infiltrated silicon carbide or aluminium oxide (alumina). Advantageously, these materials are relatively inexpensive, available and easy to work with during manufacture, resulting in high yields.

Vacuum clamping may be configured to removably secure both the first surface of the second body to the planar surface of the first body and the substrate to the second body. Vacuum clamping may be provided via the second channel of the first body via an inlet and an outlet configurable to be connected to a pressure source. Alternatively, electrostatic clamping may be configured to removably secure both the first surface of the second body to the planar surface of the first body and the substrate to the second body. Advantageously, the conditioning unit becomes a modular construction that is easy to service and repair as needed.

In a second aspect of the invention there is provided a substrate handler comprising a conditioning unit according to the invention.

In a third aspect of the invention there is provided an exposure apparatus comprising a conditioning unit according to the invention.

The embodiments of the invention may be used in or comprise a part of a substrate handling system, for example as part of an exposure apparatus.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus;
- Figure 2 depicts a schematic overview of a substrate handling system;
- Figure 3 depicts schematic assembled and exploded cross-sectional views of a conditioning unit according to an embodiment of the invention;
- Figure 4 depicts plan views of a first body and a second body of the conditioning unit of Figure 3;
- Figure 5 depicts schematic assembled and exploded cross-sectional views of a conditioning unit according to an embodiment of the invention;
- Figure 6 depicts plan views of a first body and a second body of the conditioning unit of Figure 5.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

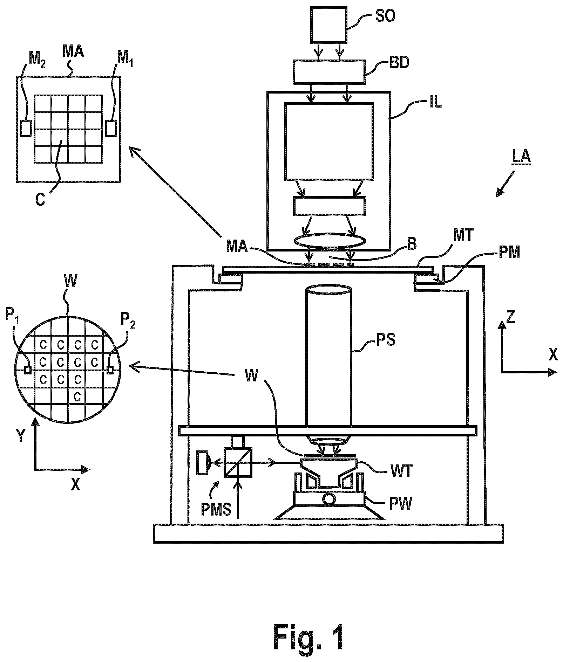

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

To clarify the invention, a Cartesian coordinate system is used. The Cartesian coordinate system has three axes, i.e., an x-axis, a y-axis and a z-axis. Each of the three axes is orthogonal to the other two axis. A rotation around the x-axis is referred to as an Rx-rotation. A rotation around the y-axis is referred to as an Ry-rotation. A rotation around about the z-axis is referred to as an Rz-rotation. The x-axis and the y-axis define a horizontal plane, whereas the z-axis is in a vertical direction. The Cartesian coordinate system is not limiting the invention and is used for clarification only. Instead, another coordinate system, such as a cylindrical coordinate system, may be used to clarify the invention. The orientation of the Cartesian coordinate system may be different, for example, such that the z-axis has a component along the horizontal plane.

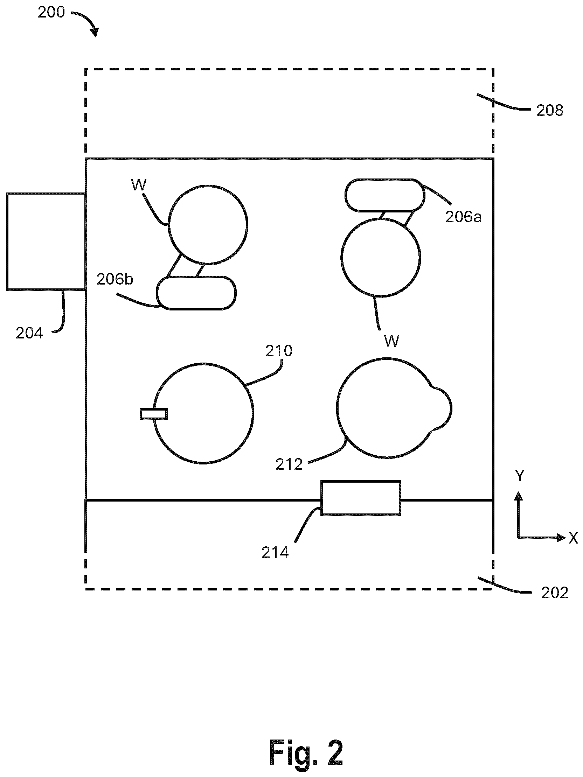

Figure 2 illustrates an exemplary substrate handling module 200. The substrate handling module 200 is configured to receive substrates W from a track 202 and/or substrate carrier 204, and to carry out functions on the substrate prior to its placement onto a substrate table, said functions for example including pre-alignment and thermal conditioning. The substrate handling module 200 may comprise one or more substrate handlers 206a-b that may be configured to provide substrates W to and/or receive substrates W from the track 202, substrate carrier 204, and/or a further module 208, which may for example be a module for exposure of a substrate, or may be a further processing module. The one or more substrate handlers 206a-b may be in a form of a robotic arm such as a Selective Compliance Assembly Robot Arm (SCARA), a linear robotic arm, or a combination thereof. The substrate handler 206a-b may include a gripper or end-effector configured to hold a substrate during the handling thereof. The gripper or end-effector may comprise one or more clamps which may be vacuum or electrostatically operable to hold a surface of the substrate. A clamp may alternatively or additionally be operable to hold a surface of the substrate under an applied force or under gravity. The substrate handler 206a-b may be configured to move substrates W between different parts of the substrate handling module 200 (e.g. moving substrates W between a measurement stage 210, a storage unit 212 and/or a track interface 214). The substrate carrier 204 may, for example, comprise a front opening unified pod (FOUP). FOUPs are used to transport substrates between lithographic apparatus and resist processing apparatus.

The substrate measurement stage 210 and/or the storage unit 212 may be configured to perform additional functions such as, for example, to correct for position offsets of the substrate and/or to thermally condition the substrate to reach a desired temperature. A measurement stage 210 may be or comprise a pre-aligner. In an example therefore, a substrate handler 206a-b may be configured to, after receiving a substrate from a track, move a substrate to a pre-aligner at the measurement stage 210 and load the substate thereon. At the pre-aligner of the measurement stage 210, coarse alignment of the substrate W may be carried out. The substrate handler 206a-b may then unload the substrate W from the pre-aligner and move it from the measurement stage 210 to a conditioning unit at the storage unit 212. The substrate handler 206a-b then loads the substrate onto the conditioning unit of the storage unit 212, where the substrate is thermally conditioned. In other examples, the measurement stage 210 comprises both a pre-aligner and a conditioning unit, and no transfer of the substrate between coarse alignment and thermal conditioning is necessary. Either one of the measurement stage 210, the storage unit 212, or an additional module (not illustrated) may further be configured to enable fine alignment of the substrate. The substrate handler 206a-b will unload and load the substrate to the necessary functional component as necessary prior to moving the substrate to a loading position for a subsequent processing step, such an exposure. The substrate handler 206a-b will in turn unload the substate following such processing steps or exposure and move the substrate as required for further processing.

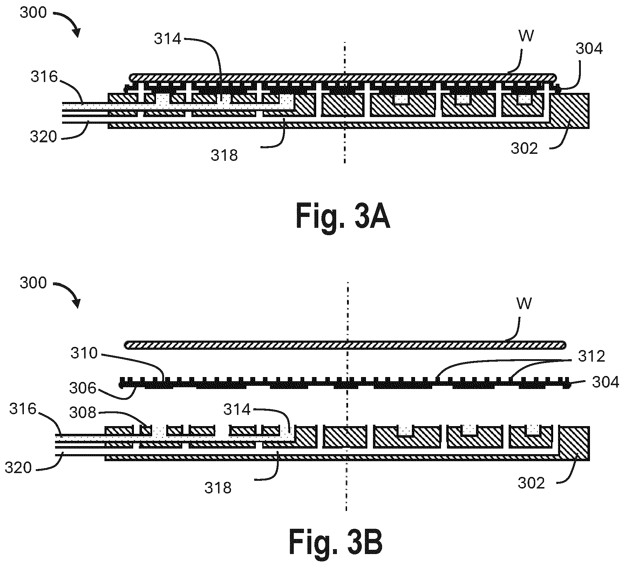

A cross-sectional view of a conditioning unit 300 according to an embodiment of the invention is illustrated in Figure 3A. The conditioning unit 300 is illustrated supporting a substrate W. Figure 3B illustrates the same conditioning unit 300 and substrate W in an exploded cross-sectional view, to better distinguish the components therein. The conditioning unit 300 comprises a first body 302 and a second body 304, on which a substrate W is supported. The second body 304 may therefore also be referred to as a substrate support or a wafer table. The first body 302 may preferably be comprised of aluminium. Alternatively, the first body 302 may be comprised of steel. The second body 304 may also be comprised of aluminium or steel, or may alternatively be comprised of steel, aluminium oxide (alumina), silicon carbide or silicon-infiltrated silicon carbide. Advantageously, these materials are relatively inexpensive, readily available and easy to work with during manufacture, resulting in high yields. Moreover, they also have a high thermal conductivity, which is necessary for the conditioning unit to ensure it can transfer heat and/or cooling as appropriate to a substrate to be conditioned.

A lower surface 306 of the second body is in communication with an upper surface 308 of the first body. The second body 304 may also be referred to as a substrate support, wherein an upper surface of the second body is a substrate-supporting surface 310. The substrate-supporting surface 310 may comprise a plurality of burls 312. A plurality of burls 312 results in a smaller contact surface area for supporting a substrate W, which advantageously reduces defectivity issues due to particles that may be trapped between the contact surface and the substrate.

The first body 302 comprises a first channel 314. The first channel 314 may also be referred to as a thermal fluid channel. The first channel 314 may be located in a transverse plane of the first body 302, in other words, the first channel 314 may extend in a plane that is substantially parallel to the upper surface 308 of the first body 302. An inlet/outlet 316 of the first channel is illustrated. For the purposes of illustration only one pathway is shown for the inlet and/or outlet. The person skilled in the art will recognise that separate pathways may be provided for the inlet and outlet. The first channel 314 may be connected to a source of thermally-controlled fluid at a manifold (not shown) and configured to convey the thermally-controlled fluid through the first body 302. The thermally-controlled fluid typically comprises purified, deionized water of a given temperature. Water has a high heat transfer coefficient and is not compressible, which makes it a suitable choice of fluid, however use of other fluids is also possible. For example, hydrogen gas may also be used as a thermally-controlled fluid, although is very expensive relative to water.

The thermal fluid channel is shown in Figure 3A as terminating at the interface between the first body 302 and the second body 304. In use, the second body 304 is secured to the first body 304 such that a seal at the interface is water-tight. In some embodiments, the seal at the interface is also air-tight and therefore the first body 302 and the second body 304 are hermetically sealed. Accordingly, there is no leakage in use of thermally-controlled fluid from the first channel 314 at the interface between the first body 302 and the second body 304.

The first body 302 further comprises a second channel 318. The second channel 318 may also be referred to as a clamping channel and is connected to a pressure source. The second channel 318 may be located in a transverse plane of the first body 302, in other words, the second channel 318 may extend in a plane that is substantially parallel to the upper surface 308 of the first body 302. The first channel 314 and the second channel 318 may be located in different transverse planes of the first body, or alternatively the first channel 314 and the second channel 318 may be located in the same plane. An inlet/outlet 320 for connection of the second channel 318 to a pressure source is illustrated. For the purposes of illustration only one pathway is shown for the inlet and/or outlet. The person skilled in the art will recognise that separate pathways may be provided for the inlet and outlet. The second channel 318 may be connected to the pressure source at a manifold (not shown). The second channel 318 terminates at the upper surface 308 of the first body 302. At the location of termination, there is no closure, therefore the second channel has a free end (or ends) such that the lower surface 306 of the second body 304 is in communication with the second channel 318 of the first body 302. The second channel 318 is is thereby configured to convey a vacuum to clamp the second body 304 to the first body 302, thereby effecting the water-tight (and, optionally, hermetic) seal between the first and second bodies. There may also be interconnecting structural features on the adjoining surfaces 306, 308 of the first and second bodies 302, 304. These are not shown in the Figures, but such structural features may serve to position the first body 302 relative to the second body 304 prior to application of vacuum through the second channel 318 to effect a water-tight and/or air-tight seal at the interface between the two bodies.

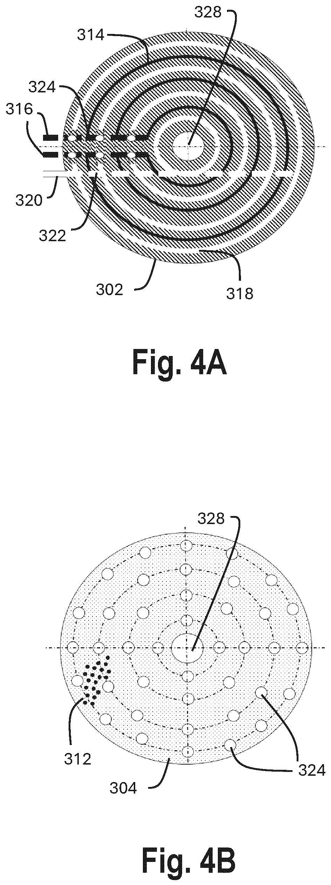

Figures 4A and 4B schematically illustrate plan views of the first body 302 and the second body 304, respectively. In Figure 4A a plurality of annular rings are shown. The dark rings correspond to parts of the first channel 314, for conveying a thermally-controlled fluid, e.g,. deionized, purified water. The light rings correspond to parts of the second channel 318 for application of clamping means, for example for application of a vacuum. The rings are solid in appearance to illustrate that both the first channel 314 and the second channel 318 are open and visible on the top surface of the first body 302. A dashed line 322 represents part of the second channel 318 from inlet 320 located in a plane below the top surface, i.e. not visible in plan view. The same applies to dashed lines 324, which represent part of the first channel 314 directed from inlet and outlet 316 located in a plane below the top surface, i.e., not visible in plan view.

The second body 304 shown in Figure 4B is illustrated with a plurality of burls 312. For the purposes of illustration, the burls are not shown covering the whole surface of the second body 304. In practice, the burls 312, if present, will be distributed across the whole area of the surface of the second body 304 that is for contacting a substrate surface. Also shown in Figure 4B are a plurality of openings 324. These openings align with the solid white lines 318 in Figure 4A, which represent the open second channel 318 areas on the top surface 308 of the first body 302, when the first body 302 is aligned in position under the second body 304. In use therefore, when a vacuum is applied through the second channel 318 of the first body 302, not only is a water-tight seal effected at the interface between the first body 302 and the second body 304, but a suction is also effected at the openings 324 of the second body. This suction in turn causes openings 324 to function as substrate clamping regions. Accordingly, the substrate W is secured to the top surface of the second body of the conditioning unit in use. Vacuum clamping is thereby configured to removably secure both the lower surface 306 of the second body 304 to the upper surface 308 of the first body 302 and the substrate W to the second body 304. A separate clamping system for the substrate W is not required, thereby keeping the complexity and cost of the conditioning unit low.

Both the first body 302 and the second body 304 are illustrated in Figures 4A and 4B with a centre opening 328. In some embodiments, the conditioning unit may have a centre opening 328 to allow for positioning of the conditioning unit on a chuck with movement in the z-direction, i.e. perpendicular to the surface plane of the conditioning chuck. This allows for ease of loading and unloading of substrates. In some embodiments, a chuck may also be rotatable to further facilitate loading and unloading actions, and potentially, in combination with e.g., an edge sensor, to allow for additional functions such as measurement of eccentricity of substrates.

In an alternative embodiment, the conditioning unit 300 may be configured to clamp the second body 304 to the first body 302 and a substrate to the second body 304 by virtue of electrostatic clamping rather than vacuum clamping. In case electrostatic clamping is implemented into the invention, a clamping sheet may be located on the lower surface 306 of the second body 304. The clamping sheet may be in communication with the burls 312 of the second body and is configured to have a voltage applied to it to create an electrostatic field and an attractive clamping force between the first body 302, second body 304, and a substrate W. A combination of electrostatic and vacuum clamping may be implemented in some embodiments.

While not shown in the embodiment of Figures 3A and 3B, the first channel 314 may be closed at the upper surface 308 of the first body by a membrane layer. Said membrane layer is typically very thin, on the order of 50-100 µm, and preferably comprises the same material as the first body 302 and/or second body 304 (i.e., aluminium, steel, aluminium oxide, silicon carbide or silicon-infiltrated silicon carbide), in order that mechanically-induced stresses due to different material coefficients of thermal expansion (CTE) is minimized, and to ensure thermal communication between the first body 302 and second body 304. The membrane may be manufactured as an integral part of the first body 302 or may be secured with an adhesive or any other suitable fixing means. A suitable adhesive may for example comprise a commercially available epoxy, e.g., Loctite^{®} EA 9460, 3M^{®} Scotch-Weld DP420, Araldite^{®} 2011 or Epo-Tek^{®} 301.

The first body 302 may be a monolithic body, meaning that the first body is a single component comprised of a single piece of material.

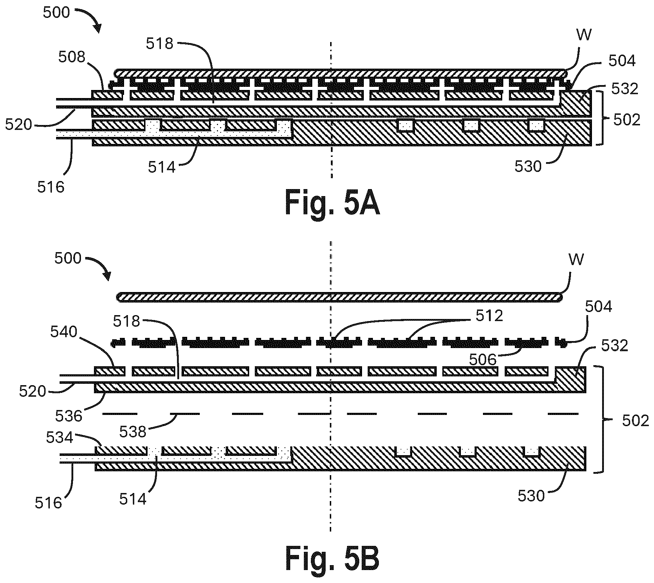

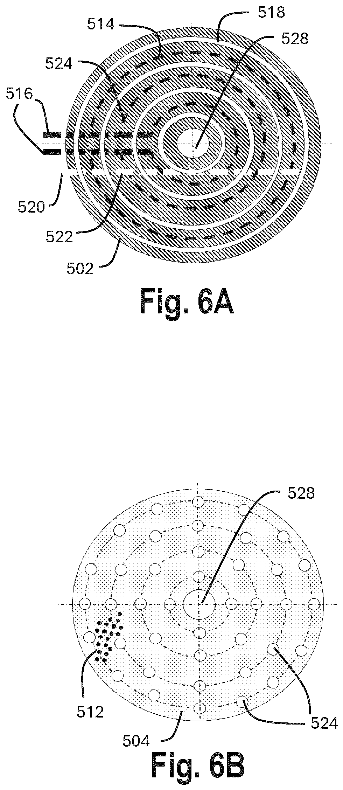

A schematic cross-sectional view of a conditioning unit 500 according to another embodiment of the invention is illustrated in Figure 5A. An exploded cross-sectional view of the conditioning unit 500 of Figure 5A is illustrated in Figure 5B. A plan view of the first body 502 is illustrated in Figure 6A and a plan view of the second body 504 is illustrated in Figure 6B. The embodiment of Figures 5A-B and 6A-B is similar to that of Figures 3A-B and 4A-B, but differs in that the first body 502 comprises a first planar body 530 and a second planar body 532.

The first planar body 530 comprises a first channel 514, which is akin to the first channel 314 of the embodiment shown in Figures 3 and 4. The first channel 514 may therefore also be referred to as a thermal fluid channel. The first channel 514 may be located in a transverse plane of the first planar body 530, in other words, the first channel 514 may extend in a plane that is substantially parallel to the top surface 534 of the first planar body 530. An inlet/outlet 516 of the first channel 514 is illustrated. For the purposes of illustration only one pathway is shown for the inlet and/or outlet. The person skilled in the art will recognise that separate pathways may be provided for the inlet and outlet. The first channel 514 may be connected to a source of thermally-controlled fluid (e.g., purified, deionized water) at a manifold (not shown) and configured to convey the thermally-controlled fluid through the first planar body 530.

The thermal fluid channel is shown in Figure 5A as terminating at the interface between the first planar body 530 and the second planar body 532. The top surface 534 of the first planar body 530 is in thermal communication with the bottom surface 536 of the second planar body 532. The exploded cross-sectional view of Figure 5B shows that a layer of adhesive 538 is used to secure the first planar body 530 to the second planar body 532. A suitable adhesive may for example comprise a commercially available epoxy, for example of the kinds listed above. Alternatively, the seal between the first planar body 530 and the second planar body 532 may be effected by a brazing process, e.g., dip brazing. The seal between the first planar body 530 and the second planar body 532 is water-tight, and optionally also air-tight such that the first planar body 530 and the second planar body 532 are hermetically sealed. Accordingly, there is no leakage in use of thermally-controlled fluid from the first channel 514 at the interface between the first planar body 530 and the second planar body 532.

The second planar body 532 comprises a second channel 518, which is akin to the second channel 318 of the embodiment of Figures 3 and 4. The second channel 518 may also be referred to as a clamping channel and is connected to a pressure source. The second channel 518 may be located in a transverse plane of the second planar body 532, in other words, the second channel 518 may extend in a plane that is substantially parallel to the upper surface 540 of the second planar body 532, which is also the upper surface 508 of the first body 502. An inlet/outlet 520 for connection of the second channel 518 to a pressure source is illustrated. For the purposes of illustration only one pathway is shown for the inlet and/or outlet. The person skilled in the art will recognise that separate pathways may be provided for the inlet and outlet. The second channel 518 may be connected to the pressure source at a manifold (not shown). The second channel 518 terminates at the upper surface 540 of the second planar body 532. At the location of termination, there is no closure, therefore the second channel has a free end (or ends) such that the lower surface 506 of the second body 504 is in communication with the second channel 518 of the first body 302. The second channel 518 is thereby configured to convey a vacuum to clamp the second body 504 to the surface of the second planar body 532, and thereby to the first body 502. This vacuum clamping effects a water-tight (and, optionally, hermetic) seal between the first and second bodies. There may also be interconnecting structural features on the adjoining surfaces 506, 508 of the first and second bodies 502, 504. These are not shown in the Figures, but such structural features may serve to position the first body 502 relative to the second body 504 prior to application of vacuum through the second channel 518 to effect a water-tight and/or air-tight seal at the interface between the two bodies.

Having the first body 502 comprised of two parts, each part with its own channel 514, 518 configured to convey either a thermally-controlled fluid or clamping means, may in some circumstances be easier to manufacture than a monolithic first body.

Figures 6A and 6B schematically illustrate plan views of the first body 502 and the second body 504, respectively. In Figure 5A a plurality of annular rings are shown. The dark, dashed rings correspond to parts of the first channel 514, for conveying a thermally-controlled fluid, e.g,. deionized, purified water. As described above with reference to Figures 5A and 5B, the first channel 514 is located in the first planar body 530, which is situated below the second planar body 532. Accordingly, the rings denoting the first channel 514 are dashed to indicate that these lie in a plane below the top surface of the first body 502, i.e. that they are not visible in plan view. The light rings correspond to parts of the second channel 518 for application of clamping means, for example for application of a vacuum. The rings are solid in appearance to illustrate that the second channel 518 is open and visible on the top surface of the first body 502. A dashed line 522 represents part of the second channel 518 from inlet 520 located in a plane below the top surface, i.e. not visible in plan view. The same applies to dashed lines 524, which represent part of the first channel 514 directed from inlet and outlet 516 located in a plane below the top surface, i.e., not visible in plan view.

The second body 504 shown in Figure 6B is the same as that shown in Figure 4B. A plurality of burls 512 are illustrated. For the purposes of illustration, the burls are not shown covering the whole surface of the second body 504. In practice, the burls 512, if present, will be distributed across the whole area of the surface of the second body 504 that is for contacting a substrate surface. Also shown in Figure 6B are a plurality of openings 524. These openings align with the solid white lines of Figure 6A, which correspond to the open second channel 518 areas on the top surface 508 of the first body 502, when the first body 502 is aligned in position under the second body 504. In use therefore, when a vacuum is applied through the second channel 518 of the first body 502, a suction is effected at the openings 524 of the second body. This suction in turn causes openings 524 to function as substrate clamping regions. Accordingly, the substrate W is secured to the top surface 508 of the second body 502 of the conditioning unit in use. Vacuum clamping is thereby configured to removably secure both the lower surface 506 of the second body 504 to the top surface 508 of the first body 502 and the substrate W to the second body 504. A separate clamping system for the substrate W is not required, thereby keeping the complexity and cost of the conditioning unit low.

Similar to the embodiment of Figures 4A and 4B, both the first body 502 and the second body 504 are illustrated in Figures 6A and 6B with a centre opening 528. In some embodiments, the conditioning unit may have a centre opening 528 to allow for positioning of the conditioning unit on a chuck with movement in the z-direction, i.e. perpendicular to the surface plane of the conditioning chuck. This allows for ease of loading and unloading of substrates. In some embodiments, a chuck may also be rotatable to further facilitate loading and unloading actions, and potentially, in combination with e.g., an edge sensor, to allow for additional functions such as measurement of eccentricity of substrates.

In an alternative embodiment, the conditioning unit 500 may be configured to clamp the second body 504 to the first body 502 and a substrate W to the second body 504 by virtue of electrostatic clamping rather than vacuum clamping. In case electrostatic clamping is implemented into the invention, a clamping sheet may be located on the lower surface 506 of the second body 504. The clamping sheet may be in communication with the burls 512 of the second body and is configured to have a voltage applied to it to create an electrostatic field and an attractive clamping force between the first body 502, second body 504, and a substrate W. A combination of electrostatic and vacuum clamping may be implemented in some embodiments.

While not shown in the embodiment of Figures 5A and 5B, the first channel 514 may be closed at the upper surface 534 of the first planar body by a membrane layer. Said membrane layer is typically very thin and preferably comprises the same material as the first body 502 and/or second body 504 (i.e., aluminium, steel, aluminium oxide, silicon carbide or silicon-infiltrated silicon carbide), in order that mechanically-induced stresses due to different material CTS is minimized, and to ensure thermal communication between the first planar body 530 and second planar body 532. The membrane may be manufactured as an integral part of the first planar body 530 or may be secured with an adhesive or any other suitable fixing means. A suitable adhesive may be of the kind outlined above for previous embodiments.

Although specific reference may be made in this text to the use of a lithographic apparatus in the manufacture of ICs, it should be understood that the apparatus described herein may be an exposure apparatus not limited to a lithographic apparatus and have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below. Other aspects of the invention are set out as in the following numbered clauses.
1. A conditioning unit for a substrate, comprising:
   a first body comprising first and second channels, each of the first and second channels in communication with one or more planar surfaces;
   a second body comprising a first surface configurable to be removably secured to a planar surface of the first body,
   the second body further comprising a second surface configured to support the substrate,
   wherein the second surface comprises a plurality of regions in communication with the second channels of the first body, configurable to secure the substrate.
2. The conditioning unit of clause 1, wherein the first surface of the second body is in communication with the second channels of the first body.
3. The conditioning unit of any preceding clause, wherein the first and second channels are located in one or more transverse planes of the first body.
4. The conditioning unit of any preceding clause, wherein the first body is a monolithic body.
5. The conditioning unit of any of clauses 1-3, wherein the first body comprises a first planar body and a second planar body, wherein a surface of the first planar body is in thermal communication with a surface of the second planar body.
6. The conditioning unit of clause 5, wherein the surface of the first planar body is sealed to the surface of the second planar body by means of an adhesive layer.
7. The conditioning unit of clause 5, wherein the surface of the first planar body is connected to the surface of the second planar body by means of dip brazing.
8. The conditioning unit of clause 6 or clause 7, wherein the seal between the first body and the second body is water-tight.
9. The conditioning unit of any of clauses 6-8, wherein the first body and the second body are hermetically sealed.
10. The conditioning unit of any preceding clause, wherein the conditioning unit is arranged to receive a substrate from a track.
11. The conditioning unit of any preceding clause, wherein the first channels are configured to convey a thermally-controlled fluid.
12. The conditioning unit of any preceding clause, wherein the second surface of the second body further comprises a plurality of burls.
13. The conditioning unit of any preceding clause, wherein the first body is comprised of aluminium or steel.
14. The conditioning unit of any preceding clause, wherein the second body is comprised of aluminium, steel, or aluminium oxide.
15. The conditioning unit of any of clauses 1-13, wherein the second body is comprised of silicon carbide or silicon-infiltrated silicon carbide.
16. The conditioning unit of any preceding clause, wherein vacuum clamping is configured to removably secure both the first surface of the second body to the planar surface of the first body and the substrate to the second body.
17. The conditioning unit of any preceding clause, wherein the plurality of regions in communication with the second channels is a plurality of openings.
18. The conditioning unit of any preceding clause, wherein the second channel of the first body is provided with an inlet and an outlet configurable to be connected to a pressure source.
19. The conditioning unit of any of clauses 1-15, wherein electrostatic clamping is configured to removably secure both the first surface of the second body to the planar surface of the first body and the substrate to the second body.
20. A substrate handler comprising the conditioning unit of any of clauses 1-19.
21. An exposure apparatus comprising the conditioning unit of any of clauses 1-19.

## Claims

1. A conditioning unit for a substrate, comprising:
a first body comprising first and second channels, each of the first and second channels in communication with one or more planar surfaces;
a second body comprising a first surface configurable to be removably secured to a planar surface of the first body,
the second body further comprising a second surface configured to support the substrate,
wherein the second surface comprises a plurality of regions in communication with the second channels of the first body, configurable to secure the substrate.

2. The conditioning unit of claim 1, wherein the first surface of the second body is in communication with the second channels of the first body.

3. The conditioning unit of any preceding claim, wherein the first and second channels are located in one or more transverse planes of the first body.

4. The conditioning unit of any preceding claim, wherein the first body is a monolithic body.

5. The conditioning unit of any of claims 1-3, wherein the first body comprises a first planar body and a second planar body, wherein a surface of the first planar body is in thermal communication with a surface of the second planar body.

6. The conditioning unit of claim 5, wherein the surface of the first planar body is sealed to the surface of the second planar body by means of an adhesive layer.

7. The conditioning unit of claim 5, wherein the surface of the first planar body is connected to the surface of the second planar body by means of dip brazing.

8. The conditioning unit of claim 6 or claim 7, wherein the seal between the first body and the second body is water-tight.

9. The conditioning unit of any preceding claim, wherein the first channels are configured to convey a thermally-controlled fluid.

10. The conditioning unit of any preceding claim, wherein the first body is comprised of aluminium or steel.

11. The conditioning unit of any preceding claim, wherein the second body is comprised of aluminium, steel, aluminium oxide, silicon carbide or silicon-infiltrated silicon carbide.

12. The conditioning unit of any preceding claim, wherein vacuum clamping is configured to removably secure both the first surface of the second body to the planar surface of the first body and the substrate to the second body.

13. The conditioning unit of any of claims 1-11, wherein electrostatic clamping is configured to removably secure both the first surface of the second body to the planar surface of the first body and the substrate to the second body.

14. A substrate handler comprising the conditioning unit of any of claims 1-13.

15. An exposure apparatus comprising the conditioning unit of any of claims 1-13.
